# EUROPEAN PATENT APPLICATION

(11) **EP 2 642 523 A2**
(43) Date of publication of application: **25.09.2013**
(21) Application number: 12161492.9
(22) Date of filing: 27.03.2012
(51) Int. Cl.: H01L 31/0216, H01L 31/0236, H01L 31/052

(54) **Cover substrate for photovoltaic module and photovoltaic module having the same**

(30) Priority: 21.03.2012 KR 20120028736
(71) Applicant: Samsung Corning Precision Materials Co., Ltd., Gyeongsangbuk-do, Gumi-si 730-735 (KR)
(72) Inventor: Kwon, YoonYoung, 336-841 Asan-si ChungCheongNam-Do (KR); Park, Kyungwook, 336-841 Asan-si ChungCheongNam-Do (KR); Nam, Jinsu, 336-841 Asan-si ChungCheongNam-Do (KR); Choi, Jeayoung, 336-841 Asan-si ChungCheongNam-Do (KR)
(74) Representative: Gulde Hengelhaupt Ziebig & Schneider

(57) **Abstract**

A cover substrate for a photovoltaic module and a photovoltaic module having the same, in which light energy is converted into electrical energy. The cover substrate includes a substrate (100) having a raised array pattern on a surface on which light is incident, and an anti-reflection film (200) formed on the surface on which light is incident.

## Description

### CROSS REFERENCE TO RELATED APPLICATION

The present application claims priority from Korean Patent Application Number 10-2012-0028736 filed on March 21, 2012, the entire contents of which application are incorporated herein for all purposes by this reference.

### BACKGROUND OF THE INVENTION

### Field of the Invention

The present invention relates to a cover substrate for a photovoltaic module and a photovoltaic module having the same, and more particularly, to a cover substrate for a photovoltaic module and a photovoltaic module having the same, in which light energy is converted into electrical energy.

### Description of Related Art

Recently, as a measure in response to the shortage of energy resources and environmental pollution, the development of photovoltaic modules is underway on a large scale. A photovoltaic module is a key device for photovoltaic power generation, which directly converts light energy, e.g. solar energy, into electrical energy.

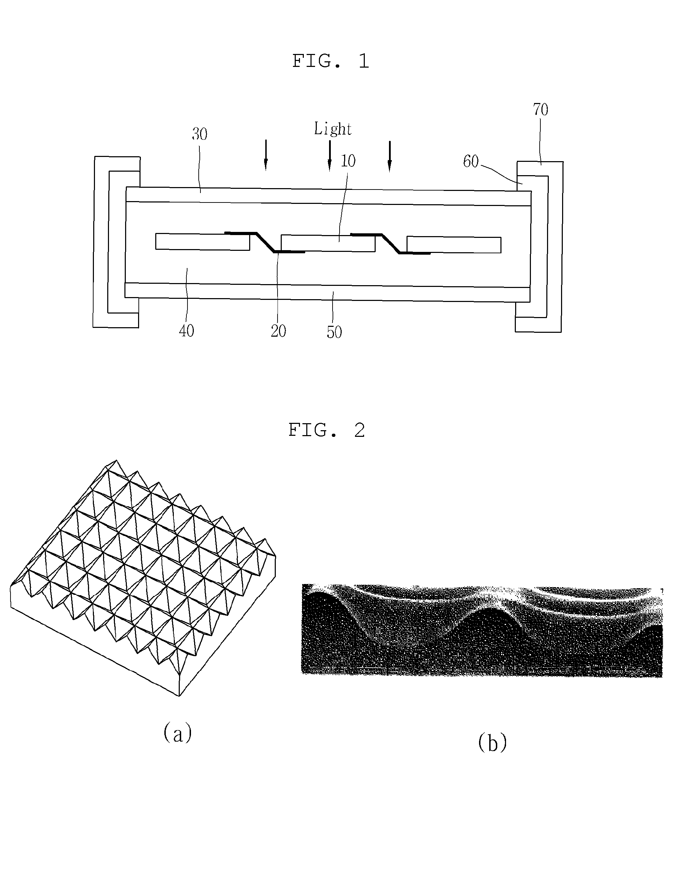

FIG. 1 is a schematic cross-sectional view of a crystalline silicon (Si) photovoltaic module of the related art.

As shown in the figure, the photovoltaic module includes photovoltaic cells 10, interconnectors (metal ribbons) 20, a cover substrate 30, a filling material 40, a back sheet 50, a sealing material 60 and a frame 70.

Each of the photovoltaic cells 10 is the smallest unit that constitutes the photovoltaic module, and serves to generate electrical energy from light that is incident thereon. Since the voltage that is generated from one photovoltaic cell is very small, i.e. about 0.5V, multiple photovoltaic cells are connected in series for use in order to generate a voltage of several volts, tens of volts, or hundreds of volts.

The cover substrate 30 is disposed in the front portion of the photovoltaic module in order to protect the photovoltaic module from the external environment.

The filling material 40 serves to protect the fragile photovoltaic cells 10, and may be made of silicone resin, polyvinyl butyral (PVB), ethylene-vinyl acetate (EVA), or the like.

The back sheet 50 is provided on the rear of the photovoltaic module, and serves to block moisture from penetrating into the photovoltaic module and to provide insulation. The back sheet 50 may be made of polyvinyl fluoride (PVF), polyester, acryl, or the like.

The sealing member 60 bonds the cover substrate 30 to the frame 70 of the photovoltaic module, thereby blocking moisture from penetrating into the inside. The sealing member 60 may be made of silicon (Si) sealant, polyurethane, polysulfide, butyl rubber, or the like.

The frame 70 is disposed on the circumference of the photovoltaic module to fix the photovoltaic module, and may be made of surface-oxidized aluminum or the like.

Here, the transmittance of the cover substrate 30 is an important factor in determining the efficiency of the photovoltaic module.

Accordingly, a variety of methods is being used in order to increase the transmittance of the cover substrate either by minimizing the internal absorption thereof by adjusting the composition of the cover substrate, or by reducing the reflective index by forming a pattern on the cover substrate.

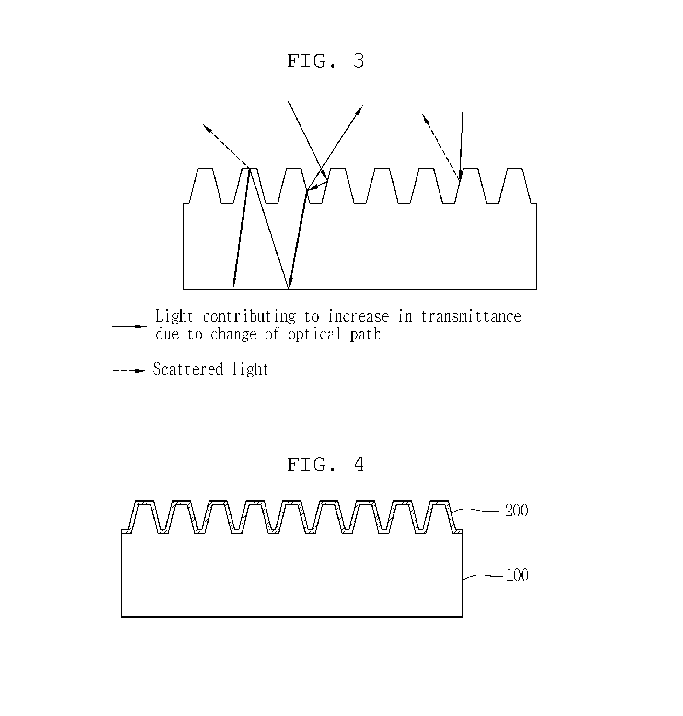

In the method of increasing the transmittance by forming the pattern on the cover substrate, as shown in FIG. 2A and FIG. 2B, it is difficult to form an actual pattern (FIG. 2B) such that it matches an optical pattern design (FIG. 2A) for high transmittance, because of actual roll-out processing. In addition, as shown in FIG. 3, there is a problem in that light is scattered by the pattern formed on the cover substrate, thereby having an adverse effect on the efficiency in which the transmittance is increased. That is, even when the pattern is formed on both sides of a flat glass panel having a transmittance of about 89% to 91%, the resultant transmittance ranges merely from 91% to 93%, which means an improvement in the transmittance of only about 1% to 2%.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a cover substrate for a photovoltaic module and a photovoltaic module having the same, in which the transmittance thereof is increased.

In an aspect of the present invention, provided is a cover substrate for a photovoltaic module. The cover substrate includes a substrate having a raised array pattern on a surface on which light is incident, and an anti-reflection film formed on the surface on which light is incident.

In an exemplary embodiment, the refractive index of the anti-reflection film may range from 1.32 to 1.39 in a wavelength range from 380nm to 770nm.

In an exemplary embodiment, the raised array pattern may be a pyramid array pattern or a truncated pyramid array pattern.

In an exemplary embodiment, the height of the pyramid or truncated pyramid array pattern may range from 80µm to 360µm.

In an exemplary embodiment, the base angle of the pyramid or truncated pyramid array pattern may be 45±5°.

In an exemplary embodiment, the cross-section of the pyramid array pattern may be an isosceles triangle, and the cross-section of the truncated pyramid array pattern may be an isosceles trapezoid.

In an exemplary embodiment, the cover substrate may further include another anti-reflection film on a light exit surface of the substrate, the refractive index of the other anti-reflection film ranging from 1.32 to 1.39 in a wavelength range from 380nm to 770nm.

In an exemplary embodiment, the units of the pyramid or truncated pyramid array pattern may define an outer profile such that a boundary between the units has an inclination that is greater than 0° but does not exceed 90° with respect to the horizontal direction.

In addition, the substrate may be made of low-iron tempered glass.

In an exemplary embodiment, the thickness of the cover substrate may range from 2.9mm to 3.65mm. More preferably, the thickness of the cover substrate ranges from 3.0mm to 3.5mm, still more preferably, the thickness of the cover substrate ranges from 3.1mm to 3.4mm and still more preferably, the thickness of the cover substrate ranges from 3.15mm to 3.25mm.

In another aspect of the present invention, also provided is a photovoltaic module that has a cover substrate. The cover substrate may include a substrate having a raised array pattern on a surface on which light is incident, and an anti-reflection film formed on the surface on which light is incident. The refractive index of the anti-reflection film may range from 1.32 to 1.39 in a wavelength range from 380nm to 770nm.

According to embodiments of the invention, it is possible to increase the transmittance of the cover substrate for a photovoltaic cell, thereby maximizing the efficiency of the photovoltaic module.

In addition, it is possible to form a raised pattern on the cover substrate for a photovoltaic module, thereby decreasing the pollution of the cover substrate due to the external environment.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a schematic cross-sectional view of a crystalline silicon (Si) photovoltaic module of the related art;

FIG. 2A and FIG. 2B are pictures depicting an optical pattern design for high transmittance and a pattern that is actually formed;

FIG. 3 is a conceptual view depicting the optical path of light that is incident on a substrate, which has a pattern thereon;

FIG. 4 is a schematic cross-sectional view depicting a cover substrate for a photovoltaic module according to an embodiment of the invention;

FIG. 5A and FIG. 5B are perspective views depicting substrates, which have a pyramidal array pattern or a truncated pyramid array pattern, respectively;

FIG. 6 is a reference view depicting the size of respective parts of the raised array pattern of the cover substrate according to an embodiment of the invention;

FIG. 7 is a graph depicting the result of a simulation on the transmittance of a substrate that has a pyramid array pattern according to an embodiment of the invention, obtained by varying the height of the pattern;

FIG. 8 is a graph depicting the result of a simulation on the transmittance of the cover substrate shown in FIG. 5B, obtained by varying the thickness thereof;

FIG. 9A and FIG. 9B are graphs depicting the transmittance of a flat substrate (without a pattern or an anti-reflection film), a patterned substrate (without an anti-reflection film), and a cover substrate having anti-reflection films on a light exit surface and a patterned surface on which light is incident; and

FIG. 10 is a graph depicting the transmittance of a flat substrate (without a pattern or an anti-reflection film), a patterned substrate (without an anti-reflection film), and a cover substrate having the anti-reflection film 1 of FIG. 9A on a patterned surface on which light is incident.

### DETAILED DESCRIPTION OF THE INVENTION

Reference will now be made in detail to various embodiments of the present invention, examples of which are illustrated in the accompanying drawings and described below, so that a person having ordinary skill in the art to which the present invention relates can easily put the present invention into practice.

In the following description of the present invention, detailed descriptions of known functions and components incorporated herein will be omitted when they may make the subject matter of the present invention unclear.

FIG. 4 is a schematic cross-sectional view depicting a cover substrate for a photovoltaic module according to an embodiment of the invention.

Referring to FIG. 4, the cover substrate for a photovoltaic module of this embodiment includes a substrate 100 and an anti-reflection film 200.

The substrate 100 protects the photovoltaic module from external environmental factors, such as moisture, dust and impacts. Here, the photovoltaic module is not limited to a silicon (Si) photovoltaic module, but may include a variety of photovoltaic modules, as long as the cover substrate can be used therewith.

The substrate 100 may be made of sodalime-based glass, and preferably low-iron tempered glass having a low surface reflective index in order to reduce the reflection loss of the glass itself. Synthetic resin, such as acryl, polycarbonate or fluorine resin, may also be used.

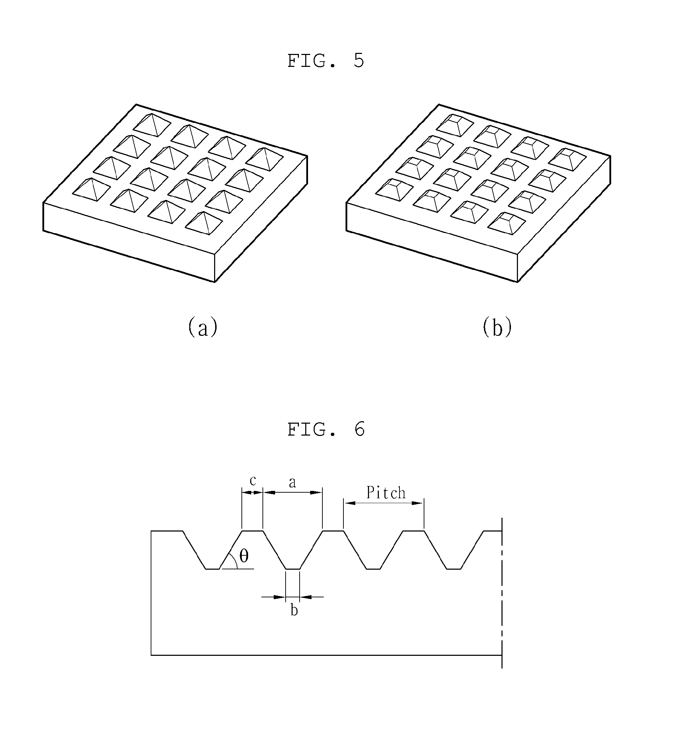

Referring to FIG. 5A and FIG. 5B, the surface of the substrate 100 on which light is incident has a pyramid array pattern (FIG. 5A) and a truncated pyramid array pattern (FIG. 5B).

This configuration is intended to minimize Fresnel loss, i.e. light loss that occurs on the surface due to Fresnel reflection when the light is incident on the cover substrate. In the case of a photovoltaic module, the lower surface of the cover substrate is the portion that is bonded to ethylene-vinyl acetate (EVA). In this case, the Fresnel loss may be disregarded.

The loss of light that is reflected from the Si surface is required to be minimized. In fact, there are several interfaces in the lower portion of the EVA. The interfaces cause a variety of types of reflection to occur, so that reflected light is refracted on the upper surface of the cover substrate, thereby causing loss.

Accordingly, the optimum conditions for increasing the efficiency of the photovoltaic module are to minimize the amount of light that is reflected from the upper surface of the cover substrate and to recycle light that would otherwise be lost by reflecting or totally reflecting it when the light again reaches the upper surface of the cover substrate after having passed through the cover substrate and then having been reflected from the several interfaces.

FIG. 6 is a reference view depicting the size of respective parts of the raised array pattern of the cover substrate according to an embodiment of the invention.

The raised array pattern can obtain maximum transmittance when its cross-section has a triangular array pattern or a trapezoidal array pattern. The triangle or trapezoid may be an isosceles triangle or an isosceles trapezoid. However, the present invention is not necessarily limited thereto.

When the base angle θ of the triangle or trapezoid satisfies the condition of 45±5°, a high transmittance can be obtained. Particularly, maximum transmittance can be expected at 45°.

Therefore, the height of the pattern is selected such that the base angle becomes 45±5° with respect to a given pitch. When "b" and "c" are decreased, transmittance is expected to increase, and can have a value of 0. The minimum value that can be manufactured is selected.

In the pattern shown in FIG. 5A, "b" has a value greater than 0. In the pattern shown in FIG. 5B, "b" and "c" are greater than 0.

The pyramid or truncated pyramid array pattern, which is formed on the surface of the substrate 100 on which light is incident, serves to increase the transmittance of the substrate by reducing Fresnel reflection. In addition, a raised pattern is formed on the surface on which light is incident in order to prevent the substrate 100 from being polluted by the external environment.

A higher transmittance can be obtained when the base angle of the pyramid or truncated pyramid array pattern is 45+5°. Preferably, at the base angle of 45°, the maximum transmittance can be expected.

It is preferred that the height of the pyramid or truncated pyramid array pattern range from 80µm to 360µm.

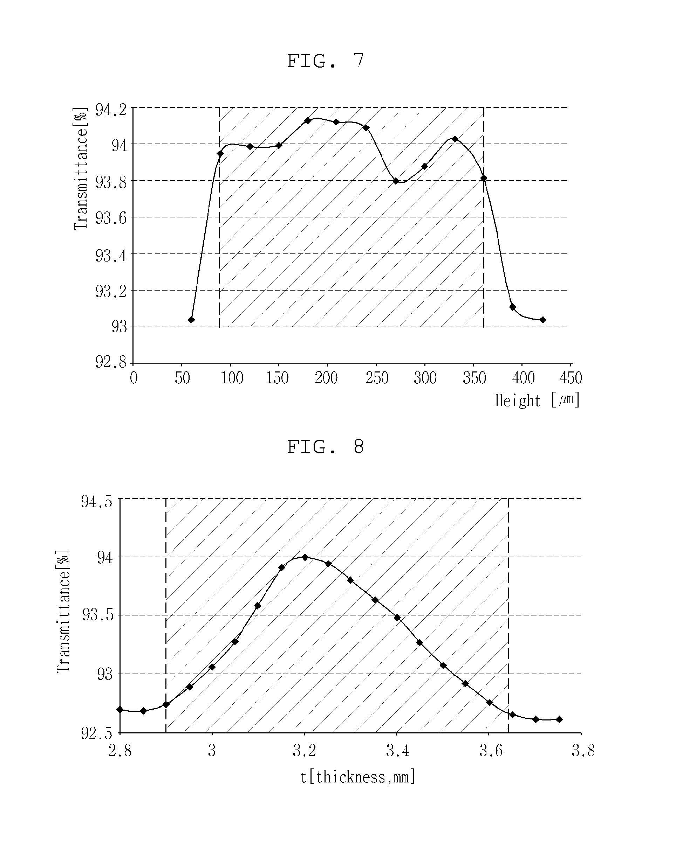

FIG. 7 is a graph depicting the result of a simulation on the transmittance of a substrate that has a pyramid array pattern according to an embodiment of the invention, obtained by varying the height of the pattern.

The transmittance measurement was carried out by irradiating sodalime glass (80mm X 80mm) with light using a D65 light source (30mm X 30mm) according to the ISO standard and measuring the transmittance using a detector (160mm X 160mm). Here, the pyramid pattern was configured such that the pitch between vertices of pyramids was 200µm and the adjoining bases of adjacent pyramids are connected to each other.

As shown in FIG. 7, it can be appreciated that the substrate having the pyramid array pattern has a high transmittance of 93.8% or more when the height of the substrate ranges from 80µm to 360µm.

In addition, it is preferred that the pyramid or truncated pyramid array pattern be configured such that rainwater or the like can easily flow down. That is, it is preferred that unit bodies of the pyramid or truncated pyramid array pattern define an outer profile such that a boundary between the units has an inclination that is greater than 0° but does not exceed 90° with respect to the horizontal direction.

The pyramid or truncated pyramid array pattern may be formed by roll-out processing.

Most attempts to increase the transmittance of the cover substrate in the related art have been focused on refinement of the shape or size of the pattern. However, the present invention proves that the increase in the transmittance by the raised array pattern can be maximized by optimizing the thickness of the cover substrate.

Although the shape and the size of the respective parts of the pattern of the cover substrate are regarded as if they might be variously changed, a variety of limitations makes it difficult to actually change such factors on-site. By way of example, although it seems that the height of the raised array pattern can be freely selected by a designer, the height or depth that can be processed is limited by the conditions at actual sites of manufacture, and is limited by the necessity to avoid adverse effects on the endurance of the cover substrate.

In addition, in order to change the shape and size of the respective parts of the pattern, considerable expenses are incurred for facilities and setting, having as a consequence the problem of increased cost of manufacturing the cover substrate and the photovoltaic module.

In contrast, the present invention proves that light transmittance can be maximized by the optimization of the raised array pattern and the thickness of the cover substrate, such that the transmittance and the resultant photovoltaic efficiency can be advantageously maximized without the foregoing problems.

The cover substrate according to an embodiment of the invention can have maximized transmittance when it has the above-described raised array pattern on the upper surface thereof, while having a thickness ranging from 2.9mm to 3.65mm.

FIG. 8 is a graph depicting the result of a simulation on the transmittance of the cover substrate shown in FIG. 5B, obtained by varying the thickness thereof.

In order to measure the transmittance, a sodalime glass cover substrate (80mm X 80mm) was irradiated with light using a D65 light source (30mm X 30mm) according to the ISO standard, and the transmittance was measured using a detector (160mm X 160mm).

A truncated pyramid array pattern, in which "a" was 371µm, "b" was 150µm, "c" was 50µm, and the height of the pattern was 150µm, was formed on the cover substrate, and then variation in the transmittance was measured by changing the thickness of the cover substrate by 50µm each time.

Table 1 presents the result of a simulation.

**Table 1**

| | | | | | | | | |
|---|---|---|---|---|---|---|---|---|
| Thickness (mm) | 2.9 | 2.95 | 3 | 3.05 | 3.1 | 3.15 | 3.2 | 3.25 |
| T (%) | 92.7 | 92.9 | 93.1 | 93.3 | 93.6 | 93.9 | 94.0 | 93.9 |
| Thickness (mm) | 3.3 | 3.35 | 3.4 | 3.45 | 3.5 | 3.55 | 3.6 | 3.65 |
| T (%) | 93.8 | 93.6 | 93.5 | 93.3 | 93.1 | 92.9 | 92.7 | 92.7 |

From Table 1 and FIG. 8, which depicts Table 3 as a graph, it can be appreciated that the transmittance was maximized when the thickness of the cover substrate ranges from 2.9mm to 3.65mm.

Accordingly, the invention provides the cover substrate, in which the surface on which light is incident has the raised array pattern, the cross-section of the raised array pattern is triangular or trapezoidal, and the thickness of the cover substrate ranges from 2.9mm to 3.65mm. This can increase the light transmittance of the cover substrate, thereby maximizing the photovoltaic efficiency of the photovoltaic module.

The anti-reflection film 200 is formed on the surface of the substrate 100 on which light is incident in order to increase the transmittance of incident light. That is, the anti-reflection film 200 increases the transmittance of light that is incident thereon by causing some components of the light, i.e. light that is reflected from the anti-reflection film and light that is reflected from the interface between the anti-reflection film and the substrate, to destructively-interfere with each other.

In addition, the anti-reflection film 200 may also be formed on the light exit surface of the substrate 100.

According to an embodiment of the invention, it is preferred that the refractive index of the anti-reflection film 200 range from 1.32 to 1.39 in a wavelength range from 380nm to 770nm.

The anti-reflection film 200 may be formed by a variety of processes, such as physical vapor deposition (PVD), chemical vapor deposition (CVD), spray coating, sol-gel dipping, or etching.

As such, the transmittance of the cover substrate for a photovoltaic module can be increased by forming the anti-reflection film on the substrate having the pyramid or truncated pyramid array pattern. That is, the cover substrate according to an embodiment of the invention can be improved in the transmittance of about 3% to 4% than the cover substrate, in which only the pyramid or truncated pyramid array pattern is formed, thereby increasing the efficiency of the photovoltaic module.

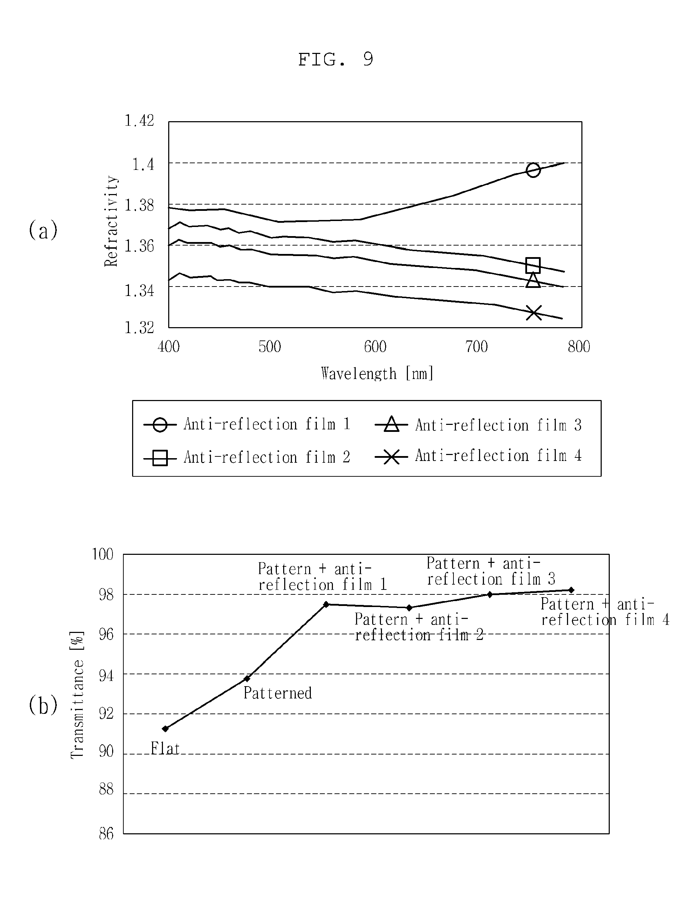

FIG. 9A is a graph depicting the refractive index of respective anti-reflection films depending on the wavelength in the wavelength range from 380nm to 770nm, and FIG. 9B is a graph depicting the transmittance of a flat substrate (without a pattern or an anti-reflection film), a patterned substrate (without an anti-reflection film), and a cover substrate having the anti-reflection films of FIG. 9A on a light exit surface and a patterned surface on which light is incident. Here, the substrate was made of sodalime glass. Referring to FIG. 9B, it can be appreciated that the transmittance of the cover substrate according to an embodiment of the invention was 97.4% or more, which is higher than that of the flat substrate and than that of the patterned substrate.

Table 2 below presents the transmittance of the flat substrate, which has the anti-reflection film shown in FIG. 9A, and the transmittance of the patterned cover substrate, which has the anti-reflection film shown in FIG. 9A.

**Table 2**

| | Transmittance of flat substrate having anti-reflection films on both surfaces (%) | Transmittance of patterned cover substrate having anti-reflection films on both surfaces (%) |
|---|---|---|
| Anti-reflection film 1 | 97.0 | 97.6 |
| Anti-reflection film 2 | 97.2 | 97.4 |
| Anti-reflection film 3 | 97.4 | 97.8 |
| Anti-reflection film 4 | 97.8 | 98.3 |

The transmittances of Table 2 above were obtained by the following simulation. I) First, anti-reflection films were set on bare glass panels (made of sodalime glass). II) Afterwards, transmittances according to the set anti-reflection films (the second column in Table 2) were calculated. III) After that, refractive indexes according to the set anti-reflection films are reversely calculated depending on the wavelength (FIG. 9A). IV) Patterns were drawn. V) Anti-reflection films having the refractive indexes depending on the wavelength (FIG. 9A) were set on the patterned surface. VI) The transmittances of the patterned cover substrates (the third column in Table 2) were calculated.

As seen from Table 2, it can be appreciated that the patterned substrate, which is coated with the anti-reflection film, according to an embodiment of the invention is improved in the transmittance of 0.2% to 0.6% than the flat substrate, which is coated with the anti-reflection film.

In a wavelength range from 380nm to 770nm, it is preferred that the refractive index depending on the wavelength range from 1.32 to 1.39. When the refractive index depending on the wavelength exceeds 1.39, the transmittance of the cover substrate is unsatisfactory, which is problematic. When the refractive index depending on the wavelength becomes smaller than 1.32, it is not easy to form an anti-reflection film having a refractive index less than 1.32.

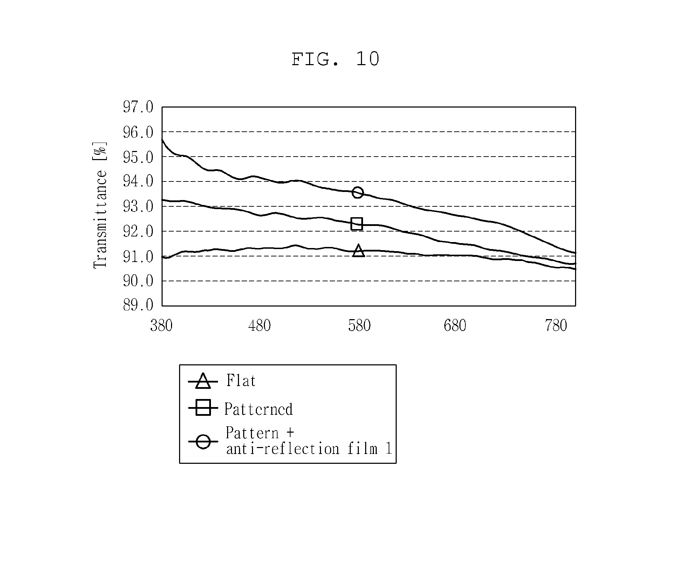

FIG. 10 is a graph depicting the transmittance of a flat substrate (without a pattern or an anti-reflection film), a patterned substrate (without an anti-reflection film), and a cover substrate having the anti-reflection film 1 of FIG. 9A on a patterned surface on which light is incident.

As seen from FIG. 10, it can be appreciated that the transmittance of the cover substrate according to an embodiment of the invention is higher than that of the flat substrate and than that of the patterned substrate across all wavelengths in the visible light range.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A cover substrate for a photovoltaic module, comprising:
a substrate having a raised array pattern on a surface on which light is incident; and
an anti-reflection film formed on the surface on which light is incident, a refractive index of the anti-reflection film ranging from 1.32 to 1.39 in a wavelength range from 380nm to 770nm.

2. The cover substrate of claim 1, wherein the raised array pattern comprises a pyramid array pattern or a truncated pyramid array pattern.

3. The cover substrate of claim 2, wherein a height of the pyramid or truncated pyramid array pattern ranges from 80µm to 360µm.

4. The cover substrate according to any one of claims 2 and 3, wherein a base angle of the pyramid or truncated pyramid array pattern is 45±5°.

5. The cover substrate according to any one of claims 2 to 4, wherein a cross-section of the pyramid array pattern is an isosceles triangle, and a cross-section of the truncated pyramid array pattern is an isosceles trapezoid.

6. The cover substrate according to any one of claims 2 to 5, wherein units of the pyramid or truncated pyramid array pattern define an outer profile such that a boundary between the units has an inclination that is greater than 0° but does not exceed 90° with respect to a horizontal direction.

7. The cover substrate according to any one of the preceding claims, further comprising another anti-reflection film on a light exit surface of the substrate, a refractive index of the another anti-reflection film ranging from 1.32 to 1.39 in a wavelength range from 380nm to 770nm.

8. The cover substrate according to any one of the preceding claims, wherein the substrate comprises low-iron tempered glass.

9. The cover substrate according to any one of the preceding claims, wherein a thickness of the cover substrate ranges from 2.9mm to 3.65mm.

10. A photovoltaic module comprising a cover substrate according to any one of the preceding claims.
